# EUROPÄISCHE PATENTSCHRIFT

(11) **EP 2 117 124 B1**
(45) Veröffentlichungstag und Bekanntmachung des Hinweises auf die Patenterteilung: **13.10.2010**
(21) Anmeldenummer: 08103812.7
(22) Anmeldetag: 05.05.2008
(51) Int. Cl.: H03M 1/08, H03M 1/12

(54) **Messdatenerfassungs-Vorrichtung sowie Verfahren zu deren Betrieb**
Data acquisition device and method for its operation
Dispositif de détermination de données de mesure et leur procédé de fonctionnement

(43) Veröffentlichungstag der Anmeldung: 11.11.2009
(73) Patentinhaber: Renner, Peter, 51515 Kürten (DE)
(72) Erfinder: Renner, Peter, 51515, Kürten (DE)
(74) Vertreter: Lippert, Stachow & Partner

(56) Entgegenhaltungen:
- WO-A-2005/104056

## Beschreibung

Die Erfindung betrifft eine mehrkanalige Messdatenerfassungseinrichtung, die zumindest eine Analogeingang-Baugruppe umfasst mit mehreren Analogeingängen, einer steuerbaren elektronischen Analogsignalschaltereinrichtung und einem zentralen, steuerbaren Analog-Digital-Wandler, wobei die Kanäle der Analogeingänge nacheinander mittels der elektronischen Analogsignalschaltereinrichtung durchschaltbar sind, sodass die an den Eingängen der einzelnen Kanäle anliegenden Analogsignale nacheinander als Eingangssignal an dem zentralen Analog-Digital-Wandler anliegen, und wobei die elektronische Analogsignalschaltereinrichtung und/oder der Analog-Digital-Wandler Steuereingänge aufweisen, die an zugeordneten Steuerleitungen angeschlossen sind. Darüber hinaus betrifft die Erfindung ein Verfahren zum Betrieb einer derartigen mehrkanaligen Messdatenerfassungsvorrichtung.

Solche Messdatenerfassungsgeräte werden insbesondere bei der Überwachung und Steuerung von technischen Prozessen eingesetzt. Dabei werden spezifische Sensoren zur Erfassung von vorgegebenen physikalischen Größen wie Temperaturen, Drücke, Durchflüsse oder Schwingungsamplituden eingesetzt, welche in der Regel analoge diesbezügliche Signale abgeben, die von dem Messdatenerfassungsgerät nach einer eventuellen Analogverstärkung einer Analog-Digital-Wandlung zugeführt und danach als digitales Signal zur nachfolgenden Datenverarbeitung, -anzeige, - speicherung etc. zur Verfügung stehen.

In dem Dokument WO 2005/104056 A2 ist ein Transmitter zur Messdatenerfassung offenbart, bei dem ein Sensorschaltkreis und Ausgangsleitungen voneinander isoliert sind. Durch die Isolation wird eine Störspannung bei der Messsignalerfassung unterdrückt.

Die Analogeingänge herkömmlicher Messdatenerfassungsgeräte sind häufig zwischen den Modi "single ended" und "Differenzeingang" umschaltbar. Bei dem erstgenannten Modus beziehen sich die analogen Eingänge auf Masse, wobei davon ausgegangen wird, dass die Masse des Sensors identisch ist mit der Masse des Messdatenerfassungsgerätes. Auf diese Weise reicht es aus, wenn jeder Sensor nur mit einer einzelnen Leitung mit dem Messdatenerfassungsgerät verbunden ist. Bei einer solchen Anschaltung eines Sensors an ein Messdatenerfassungsgerät ist kein Schutz gegen Masseschleifen gegeben, deren Auftreten die Qualität der Messdatenerfassung wesentlich beeinträchtigen.

Auch zur Verminderung der Gefahr von Masseschleifen ist bei herkömmlichen Messdatenerfassungsgeräten der Modus "Differenzeingang" wählbar, bei dem die Messsignale dem Eingang des Messdatenerfassungsgeräts zweipolig zugeführt werden. Elektromagnetische Störeinstreuungen erfolgen hier auf beide Drähte gleichzeitig, sodass derartige äußere Störungen im Wesentlichen kompensiert sind. Demgegenüber bietet dieser Modus jedoch auch keinen sicheren Schutz gegen Impedanzkopplungen durch Masseschleifen. Häufig ist es erforderlich, Messsignale, die große Potentialunterschiede aufweisen, galvanisch zu entkoppeln. Im Idealfall sind alle an das Messdatenerfassungsgerät anzuschließenden Sensoren galvanisch zu entkoppeln, was mit einem hohen apparativen Aufwand einhergeht und darüber hinaus die Messgenauigkeit vermindern kann.

Der Erfindung liegt die Aufgabe zugrunde, herkömmliche Messdatenerfassungsgeräte so weiterzubilden, dass die beschriebenen Nachteile zumindest teilweise behoben werden können.

Die Erfindung löst die obige Aufgabe überraschenderweise schon mit einer mehrkanaligen Messdatenerfassungsvorrichtung mit den Merkmalen von Anspruch 1. Bei der erfindungsgemäßen Vorrichtung sind die Versorgungsspannung der Analogeingang-Baugruppe, die Steuerleitungen der elektronischen Analogsignalschaltereinrichtung und des Analog-Digital-Wandlers sowie der Ausgang des Analog-Digital-Wandlers jeweils galvanisch von Masse entkoppelt, sodass nach der Durchschaltung eines Analogsignals an den Analog-Digital-Wandler die Analogeingang-Baugruppe den Massebezug des durchgeschalteten Analogsignals annimmt. Außerdem weist die steuerbare, elektronische Analogsignalschaltereinrichtung zwischen ihren einzelnen Analogsignalschaltern eine Spannungsfestigkeit auf, die größer ist als die zulässige Potentialdifferenz zwischen den einzelnen Kanälen. Insofern ist die Analogeingang-Baugruppe, insbesondere die Steuerleitungen der Analogsignalschaltereinrichtung und des Analog-Digital-Wandlers sowie der Ausgang des Analog-Digital-Wandlers jeweils potentialfrei, so dass diese nach dem Koppeln des jeweiligen Sensorsausgangs mit dem Eingang des Analog-Digital-Wandlers die gleiche Kopplung zur Masse wie das Analogsignal bzw. den Sensorausgang aufweist. Auf diese Weise können jegliche Masseschleifen sicher ausgeschlossen werden, und ein Übersprechen der Kanäle im Multiplexer wird vermieden, wodurch die Qualität der Messwerterfassung verbessert wird. Die erfindungsgemäße, mehrkanalige Messdatenerfassungseinrichtung "stellt" sich jeweils auf das gerade zu wandelnde Analogsignal ein, sodass eine Impedanzkopplung durch Masseschleifen zwischen Sensor und Messdatenerfassungsgerät vermieden wird. Darüber hinaus können bei der erfindungsgemäßen Messdatenerfassungsvorrichtung die zulässigen Potentialdifferenzen wesentlich erhöht werden, was den Einsatz der Vorrichtung in der Prozesstechnik erlaubt.

Der Begriff "galvanisch gekoppelt" bedeutet hier, dass zwischen zwei Leiterpunkten eine ohmsche Verbindung existiert. Entsprechend beschreibt der Begriff "galvanisch entkoppelt" in Bezug auf eine Verbindung einen Zustand, bei welchem die Verbindung entweder optisch, induktiv oder kapazitiv erfolgt. Der Begriff "Potential entkoppelt (Potential ungebunden) liegt dann vor, wenn in einem Pfad zwischen zwei Schaltungsteilen, die auf unterschiedlichen Potentialen liegen können, ein hoher Widerstand geschaltet ist, und dieser Pfad eine Spannungsfestigkeit aufweist, die höher als die zulässigen Potentialdifferenzen ist. Sowohl die Verschaltung "galvanisch entkoppelt" als auch die Verschaltung "potentialentkoppelt" werden im Folgenden als "potentialfrei" bezeichnet, wobei jedoch darauf hingewiesen wird, dass eine vollständige Entkopplung nur durch die galvanische Entkopplung bereitgestellt ist und insofern zu bevorzugen ist.

Vorteilhafte Ausführungsformen sind in den Unteransprüchen angegeben.

Zweckmäßigerweise umfasst die erfindungsgemäße Messdatenerfassungsvorrichtung eine Analogausgang-Baugruppe mit mehreren Analogausgängen und/oder eine Digital-I/O-Baugruppe, wobei die Analogausgang-Baugruppe und die Digital-I/O-Baugruppe zur Analogeingang-Baugruppe galvan entkoppelt, jedoch zumindest potentialentkoppelt sind, d.h. hohe Trennpotentiale aufweisen. entkoppelt sind. Durch diese konstruktive Maßnahme wird hergestellt, dass auch keine Masseschleifen zwischen der evtl. vorgesehenen Analogausgang-Baugruppe und der Digital-I/O-Baugruppe zur Analogeingang-Baugruppe vorliegen. Auf diese Weise können durch Masseschleifen hervorgerufene Messwertverfälschungen oder gar eine Zerstörung des Gerätes sicher vermieden werden.

In einer weiteren zweckmäßigen Ausführungsform kann vorgesehen sein, dass die Analogausgang-Baugruppe und die Digital-I/O-Baugruppe zur Analogeingang-Baugruppe zwar nicht galvanisch entkoppelt, jedoch zumindest potentialentkoppelt sind, d.h. hohe Trannpotentiale aufweisen.
Zweckmäßigerweise umfasst die erfindungsgemäße Messdatenerfassungsvorrichtung eine vorgegebene Anzahl von Anschlusseinrichtungen, welche geringer ist als die Anzahl der Ein- und Ausgänge der umfassten Eingabe/Ausgabe-Baugruppen, wobei die Anschlusseinrichtungen konfigurierbar, insbesondere frei konfigurierbar, mit den Ein- und Ausgängen der umfassten Eingabe/Ausgabe-Baugruppen verbindbar sind. Durch diese konstruktive Maßnahme wird das Problem des Missverhältnisses zwischen dem Platzbedarf für die Elektronik und dem Platzbedarf für die Anschlussklemmen bei herkömmlichen Messwerteerfassungsvorrichtungen behoben. Aufgrund von Handlings- bzw. Normungsgegebenheiten können die Anschlussklemmen nicht beliebig miniaturisiert werden, wohingegen die in derartigen Messwerteerfassungsvorrichtungen verwendete Elektronik nur noch wenig Platz einnimmt, sodass die Größe des jeweiligen Gerätes im Wesentlichen durch die Anzahl der Klemmen bestimmt wird. Andererseits ist die Größe des Gerätes in der Regel beschränkt, sodass ein Kompromiss zwischen der Anzahl der Anschlussklemmen und der Baugröße des Gerätes zu finden ist. Die beschriebene Problematik wird bei der erfindungsgemäßen Messdatenerfassungsvorrichtung dadurch behoben, dass eine geringere Anzahl von Anschlussklemmen im Vergleich zu der Anzahl der Ein-/Ausgangskanäle vorgesehen sind, wobei die Zuordnung der Kanäle zu den Anschlusseinrichtungen konfigurierbar ist. Auf diese Weise kann die erfindungsgemäße Messdatenerfassungsvorrichtung auf die jeweiligen Gegebenheiten flexibel eingestellt werden.

Besonders zweckmäßig ist es, wenn mittels einer elektronischen steuerbaren Schaltungseinrichtung die Anschlusseinrichtungen auf die jeweiligen Ein-/und Ausgänge der umfassten Eingabe/Ausgabe-Baugruppen schaltbar sind. In einer anderen, kostengünstigeren Ausführungsform werden die Verbindungen zwischen den Anschlusseinrichtungen und den Eingabe/Ausgabe-Baugruppen vom Nutzer händig wahlfrei durchgeführt, beispielsweise mittels Flachbandkabel, an deren Enden Stecker angebracht sind, die mit komplementär ausgebildeten Steckereinrichtungen in den Anschlusseinrichtungen bzw. den Eingabe/Ausgabe-Baugruppen verbindbar sind.

In einer besonders zweckmäßigen Ausführungsform sind lösbare Verbindungen zwischen den Anschlusseinrichtungen an den Ein-und Ausgängen der umfassten Eingabe/Ausgabe-Baugruppen vorgesehen, wobei die Analogeingangskanäle und die digitalen Ein-/Ausgänge jeweils zur Hälfte auf die Anschlusseinrichtungen verteilt sind.

Durch die erfindungsgemäße flexible Zuordnung der Ausgangsklemmen zu den jeweiligen Eingabe/Ausgabe-Baugruppen kann erreicht werden, dass ein einzelnes Gerät die Funktionalität mehrerer Geräte bereitstellt. Wenn beispielsweise drei Messdatenerfassungsvorrichtungen benötigt werden, eines mit 32 Analogeingängen, eines mit 32 digitalen Ein-/Ausgängen und eines mit 16 Analogeingängen und 16 digitalen Ein-/Ausgängen, so kann diese Funktionalität durch eine einzige Messdatenerfassungsvorrichtung gemäß der Erfindung realisiert werden, bei welcher die jeweiligen Anschlusseinrichtungen mittels Kabel oder steuerbarer Schaltungseinrichtung den jeweiligen Eingabe/Ausgabe-Baugruppen zugeordnet werden.

Es kann zweckmäßig sein, wenn die Messdatenerfassungsvorrichtung eine vorgegebene Anzahl von Anschlusseinrichtungen aufweist, von welchen zumindest zwei mit niedrigem Wärmeübergangswiderstand an eine wärmeleitfähige Platte thermisch gekoppelt sind. Dabei kann ein einzelner Sensor zur Messung der Temperatur der Platte vorgesehen sein, wobei die zumindest zwei Anschlusseinrichtungen zum Anschluss von Thermoelementen ausgebildet sind und wobei Messungen der zumindest zwei angeschlossenen Thermoelemente, mit dem im Wesentlichen zeitgleichen Temperaturwert des Temperatursensors an der Platte zur Ermittlung absoluter Temperaturwerte verrechnet werden. Durch eine derartige Gestaltung kann eine erfindungsgemäße Messdatenerfassungsvorrichtung zum Anschluss an mehrere Thermoelemente eingerichtet sein, wobei die Anschlussvergleichsstellen der Thermoelemente thermisch an die wärmeleitfähige Platte gekoppelt sind, sodass die Vergleichstemperatur für alle angeschlossenen Thermoelemente durch einen einzelnen Temperatursensor ermittelbar ist, was den Bauteileaufwand verringert. Dieser Vorteil zeigt sich insbesondere bei einer Messdatenerfassungsvorrichtung, die allein zum Anschließen von Thermoelementen ausgebildet ist und an der alle Anschlusseinrichtungen thermisch an die Platte angekoppelt sind, und an der insofern die Vergleichsstellen aller Thermoelemente angekoppelt sind. Ein einzelner Temperatursensor, welcher die Temperatur der Platte misst, reicht aus, um die Vergleichstemperatur für alle angeschlossenen Thermoelemente zu ermitteln.

Zweckmäßigerweise kann vorgesehen sein, dass die erfindungsgemäße Messdatenerfassungsvorrichtung zumindest eine Stromreferenzquelle umfasst, die einen Konstantstrom liefert, wobei dieser Konstantstrom über einen Ausgangsport nach außen geführt ist, insbesondere zur Bereitstellung des Konstantstroms für einen temperaturabhängigen Widerstand. Hierdurch kann die Vorrichtung auch zum Anschluss an einen temperaturabhängigen Widerstand wie ein PT100 genutzt werden, wobei der Widerstand durch die vorrichtungsseitige Stromquelle durchströmt und die am PT100 abfallende Spannung, welche ein Maß für die Temperatur des Widerstandes ist, mittels der Analogeingang-Baugruppe erfasst werden.

Um eine hohe Flexibilität der erfindungsgemäßen Messdatenerfassungsvorrichtung an den jeweils angeschlossenen Sensor bereitstellen zu können, kann vorgesehen sein, dass ein Programm zur Steuerung der Vorrichtung von einer Steuereinrichtung, einem Schnittstellencontroller, wie einem USB-Controller und/oder von einem über den USB-Controller an die Vorrichtung angeschlossenen PC bereitgestellt ist.

Hierzu kann das Programm dem Anwender Dialoge zur Verfügung stellen, die es ihm ermöglichen, jeden Kanal individuell zu konfigurieren, wobei die Konfiguration weitgehend dadurch bestimmt wird, welche Sensoren an den einzelnen Analogeingängen angeschlossen sind. Vorzugsweise kann die Software so eingestellt sein, dass in Abhängigkeit des durchzuschaltenden Eingangskanals und des daran angeschlossenen Sensors die elektronische Analogsignalschaltereinrichtung (elektrischer Multiplexer) zur Festlegung des Kanals, der Verstärkerbereich eines dem Analog-Digital-Wandler vorgeschalteten, programmierbaren Verstärkers, die Auswahl individueller, auf den Typ des Sensors bezogener Linearisierungsfunktionen und die Berechnung der gewünschten physikalischen Größen festlegbar ist. Beispielsweise kann die Kanal-individuelle Einstellung des programmierbaren Verstärkers genutzt werden, den Verstärkungswert beim Anschluss eines Thermoelementes sehr hoch einzustellen, da dieser Sensor eine sehr kleine Spannung im Millivoltbereich liefert. Die hinterlegte, sensorabhängige Linearisierungsfunktion berücksichtigt eine eventuell vorliegende nichtlineare Kennlinie des jeweiligen Sensors, die es ermöglicht, das erfasste Sensorsignal in den Ausgabewert der gewünschten physikalischen Größe umzurechnen. Beispielsweise kann bei einem angeschlossenen Drucksensor, der ein 4-20 mA Signal liefert, die zugrundeliegende physikalische Größe im beispielhaften Bereich 0 - 10 bar berechnet werden.

Verfahrensseitig wird die obige erfindungsgemäße Aufgabe gelöst durch ein Verfahren zum Betrieb einer mehrkanaligen Messdatenerfassungsvorrichtung, wobei die Analogeingang-Baugruppe potentialfrei gehalten wird, solange kein Kanal mittels der elektronischen Analogsignalschaltereinrichtung auf den Analog-Digital-Wandler durchgeschaltet ist, wobei im Falle der Durchschaltung eines Kanals auf den A/D-Wandler von der Analogeingang-Baugruppe der Massebezug des durchgeschalteten Analogsignals angenommen wird. Dabei wird für die steuerbare, elektronische Analogsignalschaltereinrichtung zwischen ihren einzelnen Analogsignalschaltern eine Spannungsfestigkeit vorgesehen, die größer ist als die zulässige Potentialdifferenz zwischen den einzelnen Kanälen.

Die Erfindung wird im Folgenden durch die Beschreibung einiger Ausführungsformen unter Bezugnahme auf die beiliegenden Figuren erläutert, wobei
- Figur 1: die schematische Darstellung einer erfindungsgemäßen Messdatenerfassungsvorrichtung,
- Figur 2: eine Baugruppe der in Figur 1 dargestellten Vorrich- tung mit Klemmen zum Anschließen von Sensoren,
- Figur 3: die in Figur 2 dargestellte Baugruppe in einer leicht geänderten Ausführungsform und
- Figur 4: eine Baugruppe mit angeschlossenem Temperatursensor, bei welcher die Konstantbestromung durch die Vor- richtung bereitgestellt wird,
zeigt.

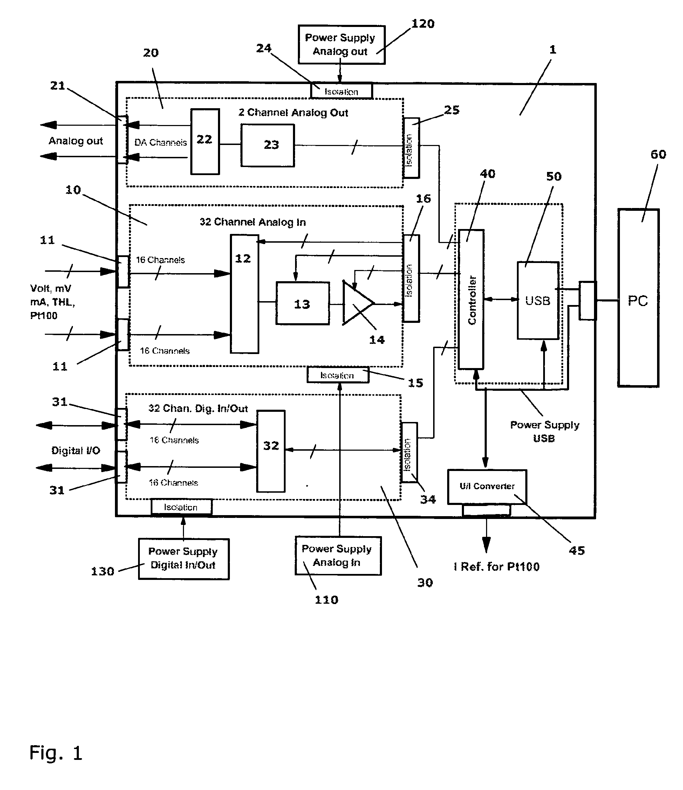

Figur 1 zeigt schematisch ein erfindungsgemäß ausgebildetes Messdatenerfassungsgerät 1, welches eine Baugruppe 10 mit 32 analogen Eingangskanälen, eine Baugruppe 20 mit zwei analogen Ausgangskanälen sowie eine Baugruppe 30 mit 32 digitalen Ein-/Ausgabekanälen aufweist. In der beschriebenen Ausführungsform sind die Baugruppen jeweils an eine zentrale Steuereinrichtung 40 angeschlossen, die wiederum über einen USB-Controller 50 mit einem externen Rechner wie einem PC 60 verbunden ist.

Die Analogeingang-Baugruppe 10 weist 32 Eingänge auf, von welchen die benutzten jeweils an eine Anschlussklemmeinrichtung 11 angeschlossen sind. Insofern kann die Analogeingang-Baugruppe 10 insgesamt 16 differentielle Eingänge bereitstellen. Die Analogeingang-Baugruppe 10 weist eine elektronische Analogsignalschaltereinrichtung 12 in Form eines Multiplexers auf, der die maximal 32 angeschlossenen Kanäle (oder 16 differentiellen Kanäle) nacheinander auf den Eingang eines Analogverstärkers 13 schaltet, dessen Ausgang mit einem Analog-Digital-Wandler 14 verbunden ist.

Die Baugruppe 10 wird von einer Spannungsversorgung 110 gespeist, wobei eine galvanische Entkopplungseinrichtung 15 in Form eines Trenntrafos dafür sorgt, dass die Spannungsversorgung der Baugruppe 10 keinen Bezug zur Masse besitzt. Ferner ist eine Steuer- und Signal-Isolationseinrichtung 16 vorgesehen, welche die zwischen dem Digital-Analog-Wandler 14 und der Steuereinrichtung 40 ausgetauschten Signale galvanisch entkoppelt, beispielsweise mittels Optokoppler.

Die beschriebenen Maßnahmen bei der Gestaltung der Analogeingang-Baugruppe 10 stellen sicher, dass die Analogeingang-Baugruppe galvanisch von Masse entkoppelt ist, solange kein Eingangskanal mittels des Multiplexers 12 auf den Verstärker 13 bzw. den Analog-Digital-Wandler 14 geschaltet ist. Hierzu ist auch die Baugruppe selbst zu dem Gehäuse des Messdatenerfassungsgerätes 1 isoliert. Durch die beschriebenen Maßnahmen wird ein Zustand einer in Bezug auf das Massepotential "schwebenden" Baugruppe 10 erreicht. Wird dagegen eines der an den Kanälen anliegenden Signale mittels des Multiplexers 12 durchgeschaltet, nimmt die Analogeingang-Baugruppe 10 den Massebezug des durchgeschalteten Analog-Signals an. Hierdurch können die bei herkömmlichen Messdatenerfassungsgeräten auftretenden Masseschleifen vermieden werden.

Das in Figur 1 dargestellte Messdatenerfassungsgerät weist ferner eine Analogausgang-Baugruppe 20 auf, die in der beschriebenen Ausführungsform eine Anschlussklemmvorrichtung 21 umfasst, welche zwei differentielle analoge Ausgangskanäle bereitstellt. Hierzu weist die Baugruppe 20 einen von der Steuereinrichtung 40 steuerbaren Digital-Analog-Wandler 23 und einen nachgeschalteten U/I-Wandler 22 auf, der ausgangsseitig mit der Anschlussklemmvorrichtung 21 verbunden ist. Zur Vermeidung der beschriebenen Masseschleifen ist auch die Baugruppe 20 bezüglich ihrer Spannungsversorgung 120 mittels einer Entkopplungseinrichtung 24 wie einem Trenntrafo galvanisch entkoppelt. Ferner ist zwischen der Steuereinrichtung 40 und der Baugruppe 20 eine Optokoppler-Einrichtung 25 zu deren galvanischen Entkopplung vorgesehen.

Die digitale I/O-Baugruppe 30 weist eine digitale 32-kanalige I/O-Einrichtung 32 zur Ausgabe bzw. Eingabe von digitalen Signalen auf, welche einerseits über eine Entkopplereinrichtung wie eine Optokoppler-Einrichtung 34 mit der Steuereinrichtung 40 verbunden ist und andererseits mit einer vorgegebenen Anzahl von Anschlussklemmeneinrichtungen 31.

In der beschriebenen Ausführungsform sind die Anschlussklemmeinrichtungen 21, 11, 31 nicht mit den einzelnen Baugruppen 10, 20, 30 fest verbunden, sondern frei konfigurierbar, sodass das Gerät sehr flexibel an die jeweilige Einsatzaufgabe angepasst werden kann. Hierdurch können letztlich Anschlussklemmen eingespart werden, da es in der Regel nicht notwendig ist, alle intern schaltbaren Kanäle nach außen zu führen.

In einer nicht dargestellten Ausführungsform kann auch vorgesehen sein, dass die Anschlussklemmen mittels einer elektronisch steuerbaren Schaltungseinrichtung frei konfigurierbar auf die jeweiligen Ausgänge bzw. Eingänge der Baugruppen 10, 20 und 30 schaltbar sind.

Das in Figur 1 dargestellte Messdatenerfassungsgerät weist ferner einen U/I-Wandler auf, welcher zur Ausgabe eines Konstantstromes ausgebildet ist, beispielsweise zur Bestromung eines PT100 oder PT1000.

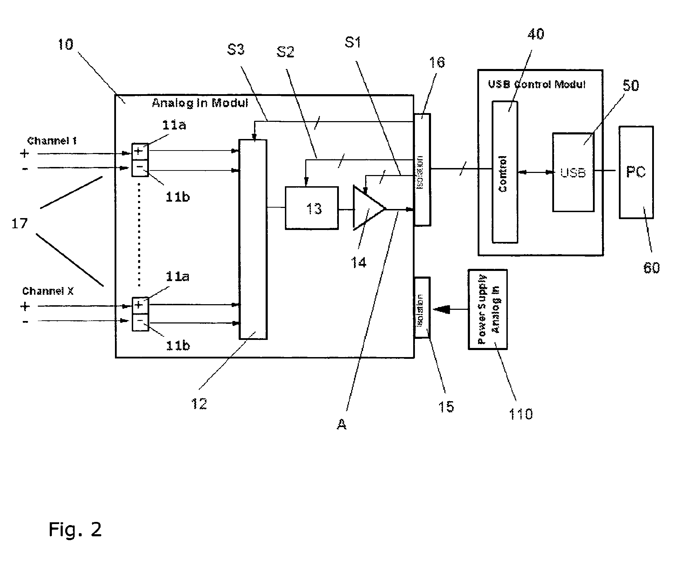

Um zu vermeiden, dass die Massebezüge mehrerer an die Analogeingang-Baugruppe über unterschiedliche Kanäle angeschlossenen Sensoren im Multiplexer 12 gekoppelt werden, weist dieser zwischen seinen einzelnen Analogsignalschalter eine hohe Spannungsfestigkeit auf, die größer ist als die zulässige Potentialdifferenz der einzelnen Kanäle, siehe Fig. 2, in welcher die Analogeingang-Baugruppe dargestellt ist. Jeder differentielle Eingangskanal 17 umfasst zwei Eingangsleitungen, welche an die beiden Klemmen 11a, 11b der zugeordneten Anschlussklemmeinrichtung 11 angeschlossen sind. In Abhängigkeit des vom jeweiligen Sensor abgegebenen Messsignals werden der Analogsignal-Multiplexer 12, der Analogverstärker 13 sowie der Analog-Digital-Wandler 14 von der Steuereinrichtung 40 über Steuerleitungen S1, S2 und S1 galvanisch isoliert angesteuert.

Die jeweiligen, Kanal- und damit Sensor-bezogenen Steuerungsparameter werden vom Anwender vorgewählt und im Rahmen des Ablaufs eines Messdatenerfassungsprogramms, beispielsweise aus einem Speicher abgerufen und eingestellt. Beispielsweise können in dem auf dem PC 60 ablaufenden Programm Dialoge zur Verfügung gestellt werden, die es dem Anwender ermöglichen, jeden Kanal individuell zu konfigurieren, die im Wesentlichen dadurch festgelegt wird, welcher Sensor an dem jeweiligen Analogeingang angeschlossen ist, und welche physikalische Größe der Messung zugrunde liegt.

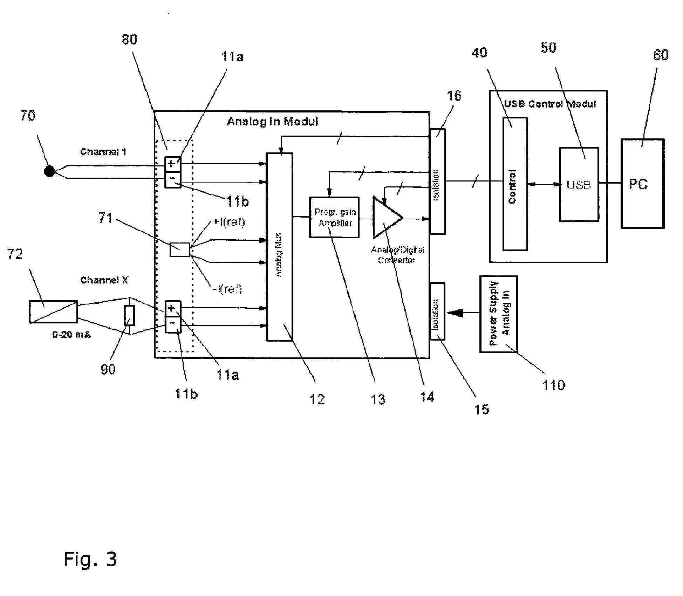

Figur 3 zeigt die in Figur 2 dargestellte Baugruppe in einer Einsatzsituation, bei welcher drei Sensoren 70, 71 und 72 jeweils zweipolig an dem Multiplexer 12 angeschlossen sind. In der in Figur 3 dargestellten Ausführungsform weist das Messdatenerfassungsgerät zusätzlich eine Metallplatte 80 aus einem Material mit hoher Wärmeleitfähigkeit auf, wobei die Anschlussklemmen 11a, 11b mit niedrigem Wärmeübergangswiderstand an die Platte 80, beispielsweise mittels eines Wärmeleitklebers, angebracht sind. Die Platte wirkt insofern als Wärmebad, sodass alle daran angekoppelten Anschlussklemmen die gleiche Temperatur aufweisen. Diese Ausführungsform eignet sich besonders in solchen Fällen, bei welchen mehrere Thermoelemente angeschlossen sind zur Erfassung verschiedener Temperaturen an unterschiedlichen Orten. Das von solchen Thermoelementen abgegebene Spannungssignal ist abhängig von der Temperaturdifferenz zwischen der eigentlichen Messstelle, in der Figur mit dem Bezugszeichen 70 gekennzeichnet, sowie einer Vergleichsstelle, die in der beschriebenen Ausführungsform durch die Platte 80 bereitgestellt wird. Zur Berechnung der absoluten Temperatur an der Messstelle ist insofern die Kenntnis über die Temperatur an der Vergleichsstelle, d.h. der Platte 80 notwendig. Bei dem beschriebenen Messdatenerfassungsgerät ist hierzu ein temperaturabhängiger Widerstand 71 im thermischen Kontakt mit der Platte 80 vorgesehen, welcher mit einem Referenzstrom IRef bestromt wird und an dem somit eine temperaturabhängige Spannung abfällt, die über einen internen Kanal an einen Eingang des Multiplexer 12 angelegt ist. In der Figur ist nur ein einzelnes Thermoelement 70 dargestellt, grundsätzlich kann eine Vielzahl solcher Thermoelemente angeschlossen sein, wobei nur eine einzelne Temperaturreferenzmessung mittels des Temperatursensors 71 durchgeführt werden muss.

Neben den beschriebenen Thermoelementen ist es ohne weiteres auch möglich, zusätzlich andere Sensoren anzuschließen. Figur 3 zeigt einen Drucksensor 72, welcher in Abhängigkeit des am Messort herrschenden Druckes einen Gleichstrom abgibt, der an einem Shunt 90 eine Spannung erzeugt, die mittels eines weiteren Messkanals zum Multiplexer 12 geführt ist.

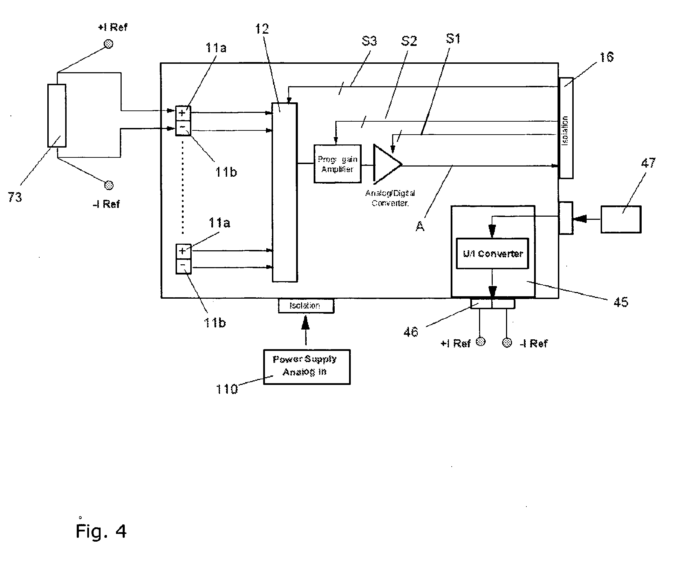

Wie in Figur 4 dargestellt, kann das Messdatenerfassungsgerät auch eine Einrichtung 45 in Form eines steuerbaren U/I-Konverters zur Bereitstellung eines vorgegebenen Konstantstromes IRef aufweisen, der über die Anschlussklemme 46 an einen äußeren Sensor, beispielsweise einen temperaturabhängigen Widerstand 73 in Form eines PT100 oder PT1000 abgeben kann. Dabei wird der U/I-Wandler 45 durch eine entsprechende Versorgung 47 gespeist.

Wie oben stehend schon erläutert, werden in der Analogeingang-Baugruppe 10 der Multiplexer, der Analogverstärker sowie der Analog-Digital-Konverter je nach durchzuschaltendem Kanal auf den jeweils angeschlossenen Sensor angepasst. Darüber hinaus wird das erfasste, digitalisierte Messsignal A (Fig. 2) über Linearisierungsfunktionen, die sensortypabhängig im Speicher der Steuerungseinrichtung abgelegt sind, datenverarbeitet, um insbesondere nichtlineare Kennlinien des Sensors zu kompensieren. Die so ermittelten Werte der gemessenen physikalischen Größen stehen dann für die weitere Verarbeitung, Speicherung, Anzeige etc. zur Verfügung. Diese beschriebene Anpassung kann je nach Ausführungsform sowohl den Steuereinrichtungen 40, 50 oder in dem externen PC 60 durchgeführt werden.

### Bezugszeichenliste

- 1: Messdatenerfassungsgerät
- 10: Analogeingang-Baugruppe
- 11: Anschlussklemmeinrichtung
- 11a, 11b: Klemme
- 12: Analogsignalschaltereinrichtung, Multiplexer
- 13: Analogverstärker
- 14: Analog-Digital-Wandler
- 15: Entkopplungseinrichtung, Trenntrafo
- 16: Steuer- und Signal-Isolationseinrichtung
- 17: Kanal
- 20: Analogausgang-Baugruppe
- 21: Anschlussklemmvorrichtung
- 22: U/I-Wandler
- 23: D/A-Wandler
- 24: Entkopplungseinrichtung, Trenntrafo
- 25: Entkopplungseinrichtung, Optokopplereinrichtung
- 30: Digital-I/U-Baugruppe
- 31: Anschlussklemmeinrichtung
- 32: Digitale I/O-Einrichtung
- 33: Entkopplungseinrichtung
- 34: Entkopplungseinrichtung, Optokoppler
- 40: Steuereinrichtung
- 45: U/I-Wandler
- 46: Anschlussklemmeinrichtung
- 47: Versorgung des U/I-Wandlers
- 50: USB-Controller
- 60: PC
- 70, 71, 72, 73: Sensor
- 80: Wärmeleitplatte
- 90: Shunt
- 110: Spannungsversorgung für Baugruppe 10
- 120: Spannungsversorgung für Baugruppe 20
- 130: Spannungsversorgung für Baugruppe 30
- S1, S2 S3: Steuerleitung/Steuersignal
- A: Digitalisiertes Messsignal
- IRef: Konstantstrom

## Patentansprüche

1. Mehrkanalige Messdatenerfassungsvorrichtung (1), die zumindest eine Analogeingang-Baugruppe (10) umfasst mit mehreren Analogeingängen, einer steuerbaren elektronischen Analogsignalschaltereinrichtung (12) und einem zentralen, steuerbaren Analog-Digital-Wandler (14), wobei die Kanäle (17) der Analogeingänge nacheinander mittels der Analogsignalschaltereinrichtung (12) durchschaltbar sind, so dass die an den Eingängen der einzelnen Kanäle anliegenden Analogsignale nacheinander als Eingangssignal an dem zentralen Analog-Digital-Wandler (14) anliegen, und wobei die elektronischen Analogsignalschaltereinrichtung und/oder der Analog-Digital-Wandler Steuereingänge aufweisen, welche an zugeordneten Steuerleitungen angeschlossen sind;
**dadurch gekennzeichnet, dass** die Versorgungsspannung der Analogeingang-Baugruppe (10), die Steuerleitungen (S3, S1) der elektronischen Analogsignalschaltereinrichtung (12) und des Analog-Digital-Wandlers (14) sowie der Ausgang des Analog-Digital-Wandlers jeweils galvanisch von Masse entkoppelt sind, sodass nach der Durchschaltung eines Analogsignals an den Analog-Digital-Wandler die Analogeingang-Baugruppe (1) den Massebezug des durchgeschalteten Analogsignals annimmt, wobei die steuerbare, elektronische Analogsignalschaltereinrichtung (12) zwischen den einzelnen Analogsignalschaltern eine hohe Spannungsfestigkeit aufweist, die größer ist, als die zulässige Potentialdifferenz der einzelnen Kanäle (17).

2. Mehrkanalige Messdatenerfassungsvorrichtung (1) nach Anspruch 1, **gekennzeichnet durch** eine Analogausgang-Baugruppe (20) mit mehreren Analogausgängen sowie eine Digital-I/O-Baugruppe (30), wobei die Analogausgang-Baugruppe und die Digital-I/O-Baugruppe zur Analogeingang-Baugruppe (10) galvanisch entkoppelt sind.

3. Mehrkanalige Messdatenerfassungsvorrichtung (1) nach Anspruch 1, **gekennzeichnet durch** eine Analogausgang-Baugruppe (20) mit mehreren Analogausgängen sowie eine Digital-I/O-Baugruppe (30), wobei die Analogausgang-Baugruppe und die Digital-I/O-Baugruppe zur Analogeingang-Baugruppe (10) potentialentkoppelt sind.

4. Mehrkanalige Messdatenerfassungsvorrichtung (1) nach einem der vorstehenden Ansprüche, **dadurch gekennzeichnet, dass** die Messdatenerfassungsvorrichtung (1) eine vorgegebene Anzahl von Anschlusseinrichtungen (11, 21, 31) aufweist, welche geringer ist als die Gesamtzahl der Ein- und Ausgänge der umfassten Eingabe/Ausgabe-Baugruppen (10, 20, 30), wobei die Anschlusseinrichtungen konfigurierbar, insbesondere frei konfigurierbar, mit den Ein- und Ausgängen der umfassten Eingabe/Ausgabe-Baugruppen verbindbar sind.

5. Mehrkanalige Messdatenerfassungsvorrichtung (1) nach Anspruch 4, **dadurch gekennzeichnet, dass** die die Anschlusseinrichtungen mittels einer steuerbaren Schaltungseinrichtung auf die Ein- und Ausgänge der umfassten Eingabe/Ausgabe-Baugruppen geschaltet sind.

6. Mehrkanalige Messdatenerfassungsvorrichtung (1) nach Anspruch 4, **dadurch gekennzeichnet, dass** lösbare Verbindungen zwischen den Anschlusseinrichtungen (11, 21, 31) und den Ein- und Ausgängen der umfassten Eingabe/Ausgabe-Baugruppen (10, 20, 30) vorgesehen sind, wobei die Analogeingangskanäle und die digitalen Ein- und Ausgänge jeweils zur Hälfte auf die Anschlusseinrichtungen verteilt sind.

7. Mehrkanalige Messdatenerfassungsvorrichtung (1) nach einem der vorhergehenden Ansprüchen, **dadurch gekennzeichnet, dass** die Messdatenerfassungsvorrichtung eine vorgegebene Anzahl von Anschlusseinrichtungen (11) aufweist, von welchen zumindest zwei thermisch mit niedrigem Wärmeübergangswiderstand an eine wärmeleitfähige Platte (80) gekoppelt sind, wobei ein Sensor (71) zur Messung der Temperatur der Platte (80) vorgesehen ist und die zumindest zwei Anschlusseinrichtungen zum Anschluss von Thermoelementen (70) ausgebildet sind und wobei Messungen der zumindest zwei angeschlossenen Thermoelemente (53) mit dem zeitgleichen Temperaturwert des Temperatursensors (71) zur Ermittlung absoluter Temperaturwerte verrechnet werden.

8. Mehrkanalige Messdatenerfassungsvorrichtung (1) nach den vorhergehenden Ansprüchen, **dadurch gekennzeichnet, dass** zumindest eine Stromreferenzquelle (45) vorgesehen ist, die einen Konstantstrom liefert, wobei dieser Konstantstrom über einen Ausgangsport (46) nach außen zugeführt ist, insbesondere zur Bereitstellung des Konstantstroms für einen temperaturabhängigen Widerstand (73).

9. Mehrkanalige Messdatenerfassungsvorrichtung (1) nach einem der vorhergehenden Ansprüchen, **dadurch gekennzeichnet, dass** ein Programm zur Steuerung der Vorrichtung von einer Steuereinrichtung (40), einem USB-Contoller (50) und/oder von einem über den USB-Controller (50) an die Vorrichtung angeschlossenen PC (60) bereitgestellt ist, wodurch jeder Kanal abhängig von dem daran angeschlossen Sensor individuell konfigurierbar ist.

10. Mehrkanalige Messdatenerfassungsvorrichtung (1) nach Anspruch 9, **dadurch gekennzeichnet, dass** in Abhängigkeit des durchzuschaltenden Kanals und des daran angeschlossenen Sensors die elektronische Analogsignalschaltereinrichtung (12) zur Festlegung des Kanals, der Verstärkerbereich eines dem Analog-Digital-Wandler (14) vorgeschalteten programmierbaren Verstärkers (13), die Auswahl individueller auf den Typ des Sensors bezogenen Linearisierungsfunktionen, und die Berechnung der gewünschten physikalischen Größe steuerbar ist.

11. Verfahren zum Betrieb einer mehrkanaligen Messdatenerfassungsvorrichtung (1), die zumindest eine Analogeingang-Baugruppe (10) umfasst mit mehreren Analogeingängen und einem zentralen Analog-Digital-Wandler (14), wobei die Kanäle der Analogeingänge nacheinander mittels einer elektronischen Analogsignalschaltereinrichtung (12) durchgeschaltet werden, sodass die an den Eingängen der einzelnen Kanäle anliegenden Analogsignale nacheinander an den zentralen Analog-Digital-Wandler (14) weitergegeben und von diesem digitalisiert werden, **dadurch gekennzeichnet, dass** die Analogeingang-Baugruppe (10) potentialfrei gehalten wird, solange kein Kanal (17) mittels der elektronischen Analogsignalschaltereinrichtung (12) auf den Analog-Digital-Wandler (14) durchgeschaltet ist, wobei im Falle der Durchschaltung eines Kanals auf den Analog-Digital-Wandler von der Analogeingang-Baugruppe(1) der Massebezug des durchgeschalteten Analog-signals angenommen wird, wobei für die elektronische Analogsignalschaltereinrichtung (12) zwischen den einzelnen Analogsignalschaltern eine hohe Spannungsfestigkeit vorgesehen wird, die größer ist, als die zulässige Potentialdifferenz der einzelnen Kanäle (17).

## Claims

1. Multichannel measuring data acquisition device (1) having at least one analog input unit (10) comprising several analog inputs, a controllable electronic analog signal switch device (12) and a central controllable analog-digital converter (14), the channels (17) of the analog inputs being through-connectible one after the other by means of the analog signal switch device (12), so that the analog signals applied to the inputs of the individual channels are applied one after the other as an input signal to the central analog-digital converter (14), and the electronic analog signal switch device and/or the analog-digital converter having control inputs that are connected to assigned control lines;
**characterized in that** the supply voltage of the analog input unit (10), the control lines (S3, S1) of the electronic analog signal switch device (12) and of the analog-digital converter (14) as well as the output of the analog-digital converter are each galvanically decoupled from the earth, so that after the through-connection of an analog signal to the analog-digital converter the analog input unit (1) adopts the ground reference of the through-connected analog signal, the controllable electronic analog signal switch device (12) between the individual analog signal switches having a high dielectric strength which is higher than the admissible potential difference of the individual channels (17).

2. Multichannel measuring data acquisition device (1) according to claim 1, **characterized by** an analog output unit (20) having several analog outputs as well as one digital I/O unit (30), the analog output unit and the digital I/O unit being galvanically decoupled with respect to the analog input unit (10).

3. Multichannel measuring data acquisition device (1) according to claim 1, **characterized by** an analog output unit (20) having several analog outputs as well as a digital I/O unit (30), the analog output unit and the digital I/O unit being potential-decoupled with respect to the analog input unit (10).

4. Multichannel measuring data acquisition device (1) according to one of the preceding claims, **characterized in that** the measuring data acquisition device (1) includes a predetermined number of connection devices (11, 21, 31), which number is smaller than the total number of inputs and outputs of the comprised input/output units (10, 20, 30), the connection devices being connectible to the inputs and outputs of the comprised input/output units in a configurable fashion and particularly in a freely configurable fashion.

5. Multichannel measuring data acquisition device (1) according to claim 4, **characterized in that** the connection devices are connected to the inputs and outputs of the comprised input/output units by means of a controllable switching device.

6. Multichannel measuring data acquisition device (1) according to claim 4, **characterized in that** the detachable connections between the connection devices (11, 21, 31) and the inputs and outputs of the comprised input/output units (10, 20, 30) are provided, one half each the analog input channels and the digital inputs and outputs being distributed to the connection devices.

7. Multichannel measuring data acquisition device (1) according to one of the preceding claims, **characterized in that** the measuring data acquisition device comprises a predetermined number of connection devices (11), at least two thereof being coupled to a thermally conducting plate (80) at a thermally low heat transmission resistance, with a sensor (71) for measuring the temperature of the plate (80) being provided and the at least two connection devices being designed for the connection of thermal elements (70) and measurements of at least two connected thermal elements (53) being set off against with the simultaneous temperature value of the temperature sensor (71) for the determination of absolute temperature values.

8. Multichannel measuring data acquisition device (1) according to one of the preceding claims, **characterized in that** at least one current reference source (45) is provided that delivers a constant current, said constant current being fed outwards through an output port (46), especially for providing the constant current for a resistor (73) which is variable with temperature.

9. Multichannel measuring data acquisition device (1) according to one of the preceding claims, **characterized in that** a program for controlling the devices is provided by a control device (40), a USB controller (50) and/or a PC (60) connected to the device via the USB controller, whereby each channel can be individually configured in dependence of the sensor connected to it.

10. Multichannel measuring data acquisition device (1) according to claim 9, **characterized in that** in response to the channel to be through-connected and the sensor connected to it, the electronic analog signal switch device (12) for the determination of the channel, the amplifier region of a programmable amplifier (14) arranged upstream of the analog-digital converter (14), the selection of individual linearization functions related to the type of sensor, and the computation of the desired physical parameter are controllable.

11. Process for operating a multichannel measuring data acquisition device (1) having at least one analog input unit (10) comprising several analog inputs and a central digital-analog converter (14), the channels of the analog inputs being through-connected one after the other by means of an electronic analog signal switch device (12), so that the analog signals applied to the individual channels are passed on one after the other to the central analog-digital converter (14) and are digitalized by this converter, **characterized in that** the analog input unit (10) is kept potential-free as long as no channel (17) is through-connected to the analog-digital converter (14) by means of the analog signal switch device (12), wherein in the case of the through-connection of a channel to the analog-digital converter of the analog input unit (1) the earth reference of the through-connected analog signal is adopted

## Revendications

1. Dispositif multi-canaux de détermination de données de mesure (1), qui comporte au moins une unité d'entrée analogue (10) comprenant plusieurs entrées analogues, un dispositif électronique gouvernable d'interrupteur de signalisation analogue (12) et un convertisseur analogique-digital central gouvernable (14), les canaux (17) des entrées analogues étant connectables l'un après l'autre par le moyen du dispositif d'interrupteur de signalisation analogue (12) de sorte que les signaux analogues appliqués aux entrées des canaux individuels sont appliqués l'un après l'autre comme un signal d'entrée au convertisseur analogique-digital central (14) et l'interrupteur électronique de signalisation analogue et/ou le convertisseur analogique-digital comprenant des entrées de commande qui sont connectées aux conduites de commande assignées,
**caractérisé en ce que** la tension d'alimentation de l'unité d'entrée analogue (10), les conduites de commande (S3, S1) d l'interrupteur électronique de signalisation analogue (12) et du convertisseur analogique-digital central (14) aussi que la sortie du convertisseur analogique-digital sont chacun découplés de la masse de manière galvanique, de sorte que après l'interconnexion d'un signal analogue au convertisseur analogique-digital l'unité de l'entrée analogue (1) adapte la référence de masse du signal analogue interconnecté, le dispositif électronique gouvernable d'interrupteur de signalisation analogue (12) ayant entre les interrupteurs de signalisation analogue une haute rigidité diélectrique qui est plus grande que la différence de potentiel admissible des canaux (17) individuels.

2. Dispositif multi-canaux de détermination de données de mesure (1) selon la revendication 1, **caractérisé par** une unité de sortie analogue (20) comprenant plusieurs sorties analogues ainsi qu'une unité digitale d'input et d'output (30), l'unité de sortie analogue et l'unité digitale d'input et d'output étant découplées de manière galvanique par rapport à l'unité d'entrée analogue (10).

3. Dispositif multi-canaux de détermination de données de mesure (1) selon la revendication 1, **caractérisé par** une unité de sortie analogue (20) comprenant plusieurs sorties analogues ainsi qu'une unité digitale d'input et d'output (30), l'unité de sortie analogue et l'unité digitale d'input et d'output étant découplées en potentiel par rapport à l'unitée d'entrée analogue (10).

4. Dispositif multi-canaux de détermination de données de mesure (1) selon l'une quelconque des revendications précédentes, **caractérisé en ce que** le dispositif de détermination de données de mesure (1) comporte un nombre prédéterminé de dispositifs de connexion (11, 21, 31), nombre qui est inférieur au nombre total des entrées et sorties des modules de construction d'entrée et de sortie (10, 20, 30) y compris, les dispositifs de connexion étant connectable aux entrées et sorties des modules de construction d'entrée et de sortie (10, 20, 30) y compris d'une manière configurable, notamment d'une manière librement configurable.

5. Dispositif multi-canaux de détermination de données de mesure (1) selon la revendication 4, **caractérisé en ce que** les dispositifs de connexion sont accrochés sur les entrées et les sorties des unités entrée/sortie comprises, par le moyen d'un dispositif de commande gouvernable.

6. Dispositif multi-canaux de détermination de données de mesure (1) selon la revendication 4, **caractérisé en ce que** des connexions détachables sont prévues entre les dispositifs de connexion (11, 21, 31) et les entrées et les sorties des unités entrée/sortie (10, 20, 30), les canaux analogues d'entrée et les entrées et les sorties digitales étant distribués chacun à moitié sur les dispositifs de connexion.

7. Dispositif multi-canaux de détermination de données de mesure (1) selon l'une quelconque des revendications précédentes, **caractérisé en ce que** le dispositif multi-canaux de détermination de données de mesure comporte un nombre prédéterminé de dispositifs de connexion (11) dont deux au moins sont couplés thermiquement et sur une basse résistance de transfert de chaleur à une plaque conductrice de chaleur (80), un capteur (71) destiné à mesurer la température de la plaque (80) étant prévu et les au moins deux dispositifs de connexion étant agencés pour la connexion des éléments thermiques (70) et les mesures des au moins deux éléments thermiques (53) connectés étant comptés avec la valeur de température simultané du capteur de température (72), pour déterminer des valeurs absolues de température.

8. Dispositif multi-canaux de détermination de données de mesure (1) selon les revendications précédentes, **caractérisé en ce que** au moins une source de courant référence (45) est prévue qui fournie un courant constant, ledit courant constant étant fourni vers l'extérieur à travers d'un port de sortie (46), en particulier pour la mise á disposition le courant constant pour une résistance (73) variable avec la température.

9. Dispositif multi-canaux de détermination de données de mesure (1) selon les revendications précédentes, **caractérisé par** la mise à disposition d'un programme pour la commande du dispositif, au moyen du dispositif de commande (40), d'un contrôleur USB (50) et/ou d'un PC (60) connecté au dispositif par le moyen de contrôleur USB (50), par quoi chaque canal peut être configuré individuellement de manière dépendant du capteur y connecté.

10. Dispositif multi-canaux de détermination de données de mesure (1) selon la revendication 9, **caractérisé en ce que** le dispositif électronique d'interrupteur de signalisation analogue (12) destiné à la détermination du canal, la zone d'amplification d'un amplificateur programmable (13) disposé en amont d'un convertisseur analogique-digital central (14), la sélection des fonctions de linéarisation individuelles relatives au type du capteur et le calcul de la variable physique désirée peuvent être commandés en fonction du canal à interconnecter et en fonction du capteur y connecté.

11. Procédé pour l'opération d'un dispositif multi-canaux de détermination de données de mesure (1), qui comporte au moins une unité d'entrée analogue (10) comprenant plusieurs entrées analogues et un convertisseur analogique-digital central (14), les canaux (17) des entrées analogues étant interconnectés l'un après l'autre par le moyen du dispositif d'interrupteur de signalisation analogue (12) de sorte que les
signaux analogues appliqués aux entrées des canaux individuels sont transmis l'un après l'autre comme un signal d'entrée au convertisseur analogique-digital central (14) et digitalisés par celui-ci, **caractérisé en ce que** l'unité d'entrée analogue (10) est maintenue sans potentiel tant qu'aucun canal (17) est interconnecté au convertisseur analogique-digital central (14) au moyen du dispositif d'interrupteur de signalisation analogue (12), la référence de masse du signal analogue interconnecté étant adaptée en cas de l'interconnexion d'un canal au convertisseur analogique-digital central de l'unité d'entrée analogue (1) et une haute rigidité diélectrique qui est plus grande que la différence de potentiel admissible des canaux (17) individuels étant prévue pour le dispositif électronique d'interrupteur de signalisation analogue (12) entre les interrupteurs de signalisation analogues.
